(19)

Europäisches Patentamt
European Patent Office
Office européen des brevets

(11) **EP 2 180 594 A1**

(12) **EUROPEAN PATENT APPLICATION**

(43) Date of publication:
**28.04.2010 Bulletin 2010/17**

(21) Application number: **09015298.4**

(22) Date of filing: **12.12.2003**

(51) Int Cl.:
$H03F\ 1/02^{(2006.01)}$    $H03F\ 1/32^{(2006.01)}$
$H03F\ 3/181^{(2006.01)}$    $H03F\ 3/21^{(2006.01)}$
$H03F\ 3/217^{(2006.01)}$    $H03F\ 3/68^{(2006.01)}$

(84) Designated Contracting States:
**AT BE BG CH CY CZ DE DK EE ES FI FR GB GR HU IE IT LI LU MC NL PT RO SE SI SK TR**

(30) Priority: **17.12.2002 IT RE20020097**
               **17.12.2002 IT RE20020098**

(62) Document number(s) of the earlier application(s) in accordance with Art. 76 EPC:
**03028467.3 / 1 432 120**

(71) Applicant: **ASK Industries S.p.A.**
**60037 Monte San Vito (AN) (IT)**

(72) Inventors:
  • **Franceschini, Giovanni**
     **60037 Monte San Vito (AN) (IT)**

• **Bellini, Alberto**
   **60037 Monte San Vito (AN) (IT)**
• **De Benedetti, Antonio**
   **60037 Monte San Vito (AN) (IT)**
• **Burlenghi, Michele**
   **60037 Monte San Vito (AN) (IT)**
• **Ugolotti, Emanuele**
   **60037 Monte San Vito (AN) (IT)**

(74) Representative: **Lecce, Giovanni**
**Dott. Giovanni Lecce & C. S.r.l.**
**Via Fratelli Ruffini, 9**
**20123 Milano (IT)**

Remarks:
This application was filed on 10-12-2009 as a divisional application to the application mentioned under INID code 62.

(54) **Audio power amplifier**

(57)      An audio power amplifier achieved with a hybrid architecture constituted by the magnetic coupling of a linear amplifier ($Hd_{lin}$) with a switching amplifier ($Hd_{SW}$) placed on two coaxial coils of a loudspeaker (LS1), or with a hybrid architecture constituted by the electrical coupling of a linear amplifier ($Hd_{lin}$) with a switching amplifier ($Hd_{SW}$). These solutions allow obtaining an amplifier characterized by the low distortion of a linear amplifier and by the high efficiency of the switching amplifier.

FIG. 1

**Description**

The present invention refers to an audio power amplifier.

As it known, the audio power amplifiers are already widely used in various consumer electronics fields.

Switching amplifiers have recently become popular for their high performance and manufacturing at low costs.

As input, the switching amplifiers (that are also known as Class D amplifiers) receive a modulated PWM (Pulse width Modulation) signal; in order to obtain the amplification, this input is used to choke a high level voltage equal to the available supply voltage causing, in the output voltage, a high ripple turning into a high harmonic distortion of the sound produced by the loudspeaker.

Moreover the bandwidth of the switching (Class D) amplifiers is bound to the PWM modulation frequency that, due to the limited switching speed of the static switches cannot be high.

It follows that for a switching amplifier, to a high performance, a significant distortion is opposed and therefore the difficulty in obtaining a high bandwidth.

On the other hand, the distortion of the linear amplifiers that are commonly used (known in the art as Class A, AB and B amplifiers) is relatively low, but their efficiency is definitely lower than the Class D ones.

The class D (switching) amplifiers have the advantage of a high performance, i.e. they have a high ratio between the power actually supplied on the load and the one actually absorbed by the supply, but they have a limited bandwidth and their distortion increases as the signal frequency increases. Moreover, Class D amplifiers show a considerable distortion when the signal width to be amplified is lower than a threshold that, in its turn, depends on the switching frequency, the modulator topology and some intrinsic parameters (time constants of charging/discharging and transfer times) in the switching elements [MOSFET (Metal Oxide Silicon Field Effect Transistor), IGBT (Insulated Gate Bijunction Transistor)].

Linear amplifiers are instead characterized by very low distortions, high bandwidth (starting from, in decreasing order, Class A, Class AB and Class B) but they have a very low efficiency (starting from in decreasing order, Class B, Class AB, Class A).

Nowadays, many solutions can be found both in the art and in the market in order to solve:

- the efficiency problem for the linear amplifiers,
- the distortion problem in Class D amplifiers,
- the bandwidth limitation problem in Class D amplifiers.

But these solutions are separate between them, i.e. they keep the linear amplifiers separate from the switching (Class D) ones.

Object of the present invention is to remove the above-mentioned drawbacks.

According to the present invention these and other purposes resulting form the following description will be achieved by an audio power amplifier **characterized in that** it is achieved with a hybrid architecture constituted by the magnetic or electrical coupling of a linear amplifier ($HD_{lin}$) with a switching amplifier ($HD_{sw}$).

In a first solution wherein said elements are magnetically coupled ("Magnetic Tandem") an audio power amplifier characterized by the low distortion of a linear amplifier and by the high efficiency of a switching is obtained; the whole system obtained has a higher efficiency than the linear amplifier. This purpose is obtained by magnetically coupling a linear audio amplifier and a switching audio amplifier on the mobile coil of a loudspeaker; if a loudspeaker with two coaxially wrapped coils is used, the two coils can be separately controlled: one with a linear amplifier and the other one with a switching amplifier.

In a second solution wherein said elements are electrically coupled ("Electric Tandem"), the linear amplifier acts as a support to the switching amplifier compensating the intrinsic non-linearity and the bandwidth limit, the switching amplifier supplies the required high efficiency power compensating the lack of the linear amplifier; a good compromise between low distortion of the first one and the high efficiency of the second on is thus obtained. The invention is described in detail here below, according to the above-mentioned embodiments which are given only by way of non-limitative example wherein reference is made to attached drawings:

Figure 1 represents the principle scheme of an amplifier with magnetic coupling "Magnetic Tandem" and double coil loudspeaker,

Figure 2 represents the current waveform in a double coil loudspeaker powered by the "Magnetic Tandem" amplifier, compared with the current waveform in a linear amplifier and in a switching one,

Figure 3 represents the circuit scheme of the "Magnetic Tandem" amplifier,

Figure 4 represents the diagram of the distortion waveform according to the frequency, with equal power on a purely resistive load, on a double coil loudspeaker equipped with the "Magnetic Tandem" amplifier compared with the one of a switching (Class D) amplifier,

Figure 5 represents the principle scheme of an amplifier with "Electric Tandem" electric coupling,

Figure 6 represents the diagram of the "Electric Tandem" amplifier currents, compared with the separate waveforms of a linear amplifier and of a switching amplifier,

Figure 7 represents the circuit scheme of the "Electric Tandem" amplifier, and

Figure 8 represents the diagram of the distortion waveform according to the frequency, with equal power on a purely resistive load, of an "Electric Tandem" amplifier compared with the one of a linear (Class AB) amplifier and with the one of a switching (Class D) amplifier.

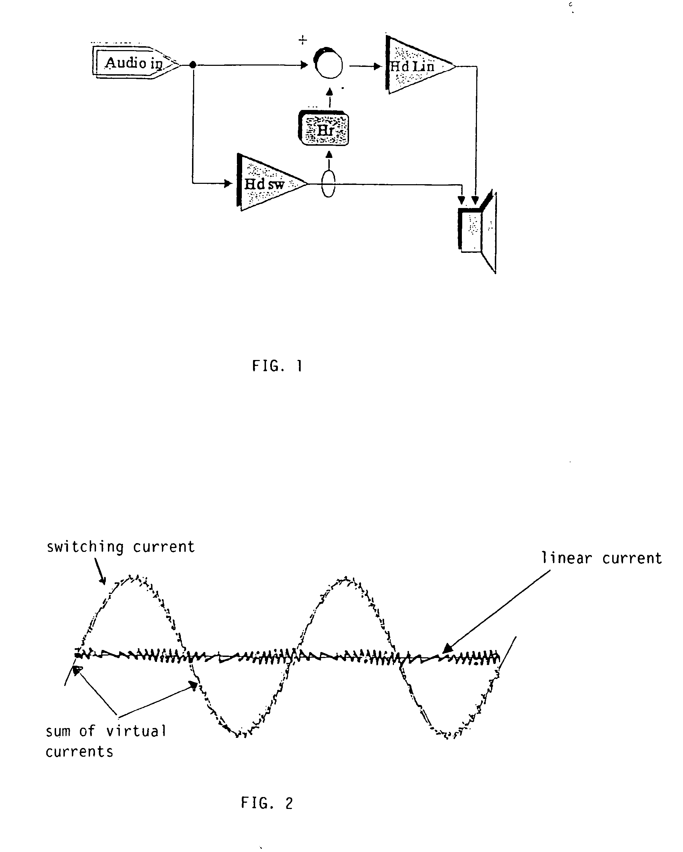

With reference to the scheme represented in Figure 1 concerning the solution of an amplifier with "Tandem Magnetic" magnetic coupling, the current on the coil pertaining to the switching amplifier is fed back, if it is picked up by means of a shunt in series and through a block with transfer function $Hr(\omega)$, on the linear amplifier having transfer function $Hd_{lin}(\omega)$.

The transfer function $Hr(\omega)$ has a particular waveform in frequency, expands the bandwidth and it also connects the current to the coil pertaining to the switching amplifier and to the input signal.

The switching amplifier with the transfer function $Hd_{sw}(\omega)$ acts as voltage generator and it is directly controlled by the audio input signal.

On the contrary, the linear amplifier $Hd_{lin}$ compensates the current ripples that are unavoidably produced by the switching amplifier $Hd_{sw}$.

The current system was fed back in a way similar to the one used in the torque control of the electric machines wherein the current ring is closed in order to control the torque. In fact, the torque of an electric machine is proportional to the current flowing in the stator (asynchronous motors) or in the rotor (continuous current motors): if the current can be modulated, the torque is also proportionally modulated; moreover there is no bind with the loading conditions of the motor and this does not occur in the usual operations wherein the voltage or the power frequency are modulated.

If the same action is carried out on the loudspeaker, the current supplied by the amplifier id independent from the voltage-current transfer function of the load being the admittance of the same load. Let's suppose that $V_{out}(\omega)$ is the output voltage of the amplifier, $I_{out}(\omega)$ the output current of the amplifier and $Z_{out}(\omega)$ the load impedance i.e. the electric impedance of the loudspeaker (with $Y_{out}(\omega)$ the relevant admittance):

$$\frac{\vec{I}_{OUT}(\omega)}{\vec{V}_{OUT}(\omega)} = \frac{1}{\vec{Z}_{OUT}(\omega)} = \vec{Y}_{OUT}(\omega)$$

The impedance of the loudspeaker $Z_{out}(\omega)$ is not constant in frequency and therefore would introduce a distortion.

Checking the current means checking the mechanical force applied to the loudspeaker cone (according to the mentioned analogy relevant to the torque control of electric machines). There is in fact a direct proportionality between the force by which the loudspeaker cone moves, i.e. the sound pressure, and the current flowing into the coil:

$$F = (B \cdot l) \cdot I_{out}$$

wherein with $(B \cdot l)$ means the factor force of the loudspeaker, defined as the magnetic flux density multiplied by the length of the mobile coil.

In Figure 2 the current flowing in the hybrid amplifier according to the present invention excited by a sinusoidal input are shown: it can be particularly noticed that the output current of the linear amplifier (linear current) acts as a real compensation of the output current of the switching amplifier (switching current) showing a sinusoidal waveform with an overlapped ripple due to the intrinsic distortion of the switching amplifier.

The combination of the currents that now is magnetically taking place, i.e. it takes place through the combination of the magnetic fields they generated, is detected as a "virtual" combination, i.e. as if it is one current flowing in one single coil, considering the reciprocal effect between the two currents being actually present.

As it ca be noticed, this current does not have distortions and it takes a sinusoidal waveform reproducing, without the waveforms unavoidably generated by the switching amplifier $Hd_{sw}$, the sinusoidal curve of the current generated by the magnetic field inside the loudspeaker. Moreover the "virtual current" is proportional to the input signal, i.e. to the signal to be reproduced.

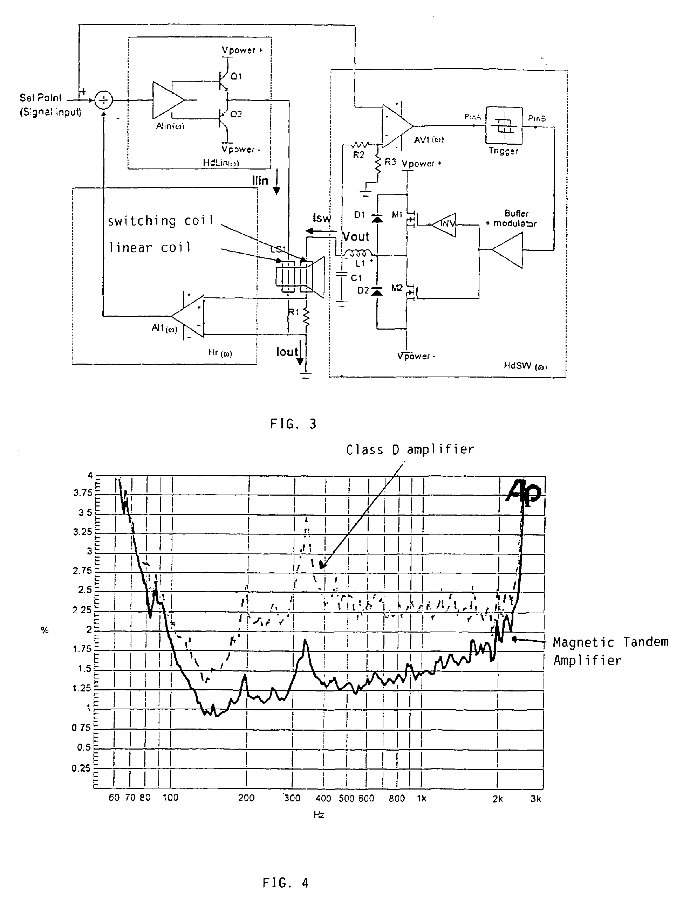

In Figure 3 the wiring diagram of the "Magnetic Tandem" amplifier according to the present invention is shown. The linear amplifier $Hd_{lin}$ supplies the current $I_{lin}$ that is sent to the coil pertaining to it of the loudspeaker LS1, while the switching amplifier $Hd_{sw}$ supplies the current $I_{sw}$ and the tension $V_{out}$ on the coil pertaining to it, of the loudspeaker LS1, by means of two power switching elements M1, M2 (usually power MOSFET). The gain of the switching amplifier $Hd_{sw}$ is determined by two resistance R2, R3. The magnetic fields determined by the two currents $I_{lin}$ and $I_{sw}$ sum up in the loudspeaker air gap thus supplying a magnetic field being proportional to the current $I_{out}$ and exactly corresponding to the sum of the two currents $I_{lin}$ and $I_{sw}$. The current $I_{sw}$ is then fed back through a shunt R1 and a differential amplifier AII (i.e. Hr $(\omega)$): the output signal of the differential amplifier is subtracted to the input signal and the result is sent to the input of the linear amplifier $Hd_{lin}$. The combination of the currents $I_{lin}$ and $I_{sw}$ giving as a result the current $I_{out}$ is highlighted in Figure 2 wherein $I_{sw}$ is the "linear current", $I_{sw}$ is the "switching current" and $I_{out}$ is the "virtual current" that creates in the air gap of the loudspeaker LS1.

The feedback of the current $I_{sw}$ through the transfer function $Hr(\omega)$ allows the linear amplifier, with transfer function $Hd_{lin}(\omega)$ to act in such a way that the current $I_{out}(\omega)$ follows the input voltage (Set point) as much as possible. In particular, by this feedback, the error signal allowing the linear amplifier $Hd_{lin}$ to generate an output current $I_{lin}$ containing both a portion of the useful current $I_{out}$ and the replica, exactly in push-pull, of the ripple unavoidably generated by the switching amplifier $Hd_{sw}$ is generated.

Figure 4 shows the total harmonic distortion plus noise THD+N (Total Harmonic Distortion + Noise) according to the frequency and with the same power on a double coil loudspeaker of a "Magnetic Tandem" amplifier, compared with the one of a switching (Class D) amplifier. It ca be deduced that the "Magnetic Tandem" amplifier keeps the linear amplifier distortion low, together with high efficiency of the switching amplifier.

The measurements are made in an anechoic chamber on a DIN 51435 baffle.

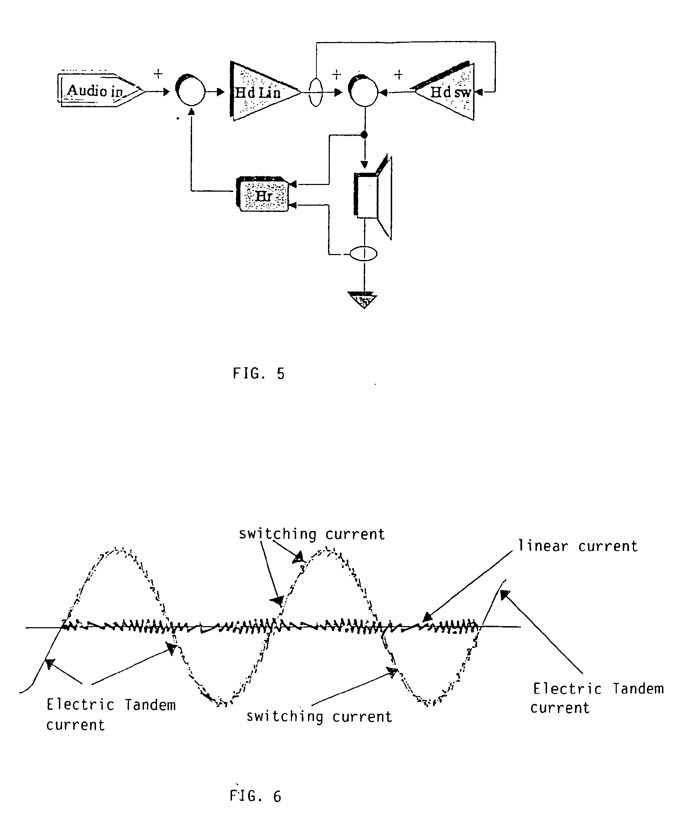

With reference to the scheme shown in Figure 5 concerning the solution of an amplifier with "Electric Tandem" electric coupling, the current on a loudspeaker LS1 is fed back if picked up with shunt in series R1 and sent, through the transfer block $Hr(\omega)$, to the linear amplifier with the transfer function $Hr_{lin}(\omega)$. The transfer function $Hr(\omega)$ has a particular waveform in frequency determining the bandwidth of the amplifier according to the present invention and provide also a mixed voltage-current feedback binding the voltage and the current across the loudspeaker.

The switching amplifier, having the transfer function $Hr_{sw}(\omega)$ acts as a current generator and it is controlled by the linear amplifier: the switching amplifier expressly helps the linear amplifier to reach the required current level.

The linear amplifier $Hd_{lin}$ compensates the current waveforms unavoidably produced by the switching amplifier $Hd_{sw}$.

The current system is fed back in a similar way compared to the one used in the torque of electric machines wherein the current ring is closed to control the torque. The torque of an electric machine is in fact proportional to the current flowing in the stator (asynchronous motors) or in the rotor (continuous current motors).

If the current can be modulated, the torque is proportionally modulated; moreover there is no bind to the load conditions of the motor; this does not occur in the usual controls wherein the voltage or the power frequency of the motor is modulated.

If this operation is carried out on a loudspeaker, the current supplied by the amplifier is independent from the voltage-current transfer function of the load being the admittance of the same load.

Let's suppose that $V_{out}(\omega)$ is the output voltage of the amplifier, $I_{out}(\omega)$ the output current of the amplifier and $Z_{out}(\omega)$ the load impedance i.e. the electric impedance of the loudspeaker (with $Y_{out}(\omega)$ the relvant admittance):

$$\frac{\vec{I}_{OUT}(\omega)}{\vec{V}_{OUT}(\omega)} = \frac{1}{\vec{Z}_{OUT}(\omega)} = \vec{Y}_{OUT}(\omega)$$

The impedance of the loudspeaker $Z_{out}(\omega)$ is not constant and therefore would introduce a distortion.

Checking the current means checking the mechanical force applied to the loudspeaker cone (according to the above-mentioned analogy concerning the electric machines for the control of the torque). There is in fact a direct proportionality between the force by which the loudspeaker cone moves, i.e. the sound pressure, and current flowing in the coil:

$$F=(B \cdot l) \cdot I_{out}$$

Wherein (B · 1) means the factor force of the loudspeaker defined as the density of magnetic flux multiplied by the length of the mobile coil.

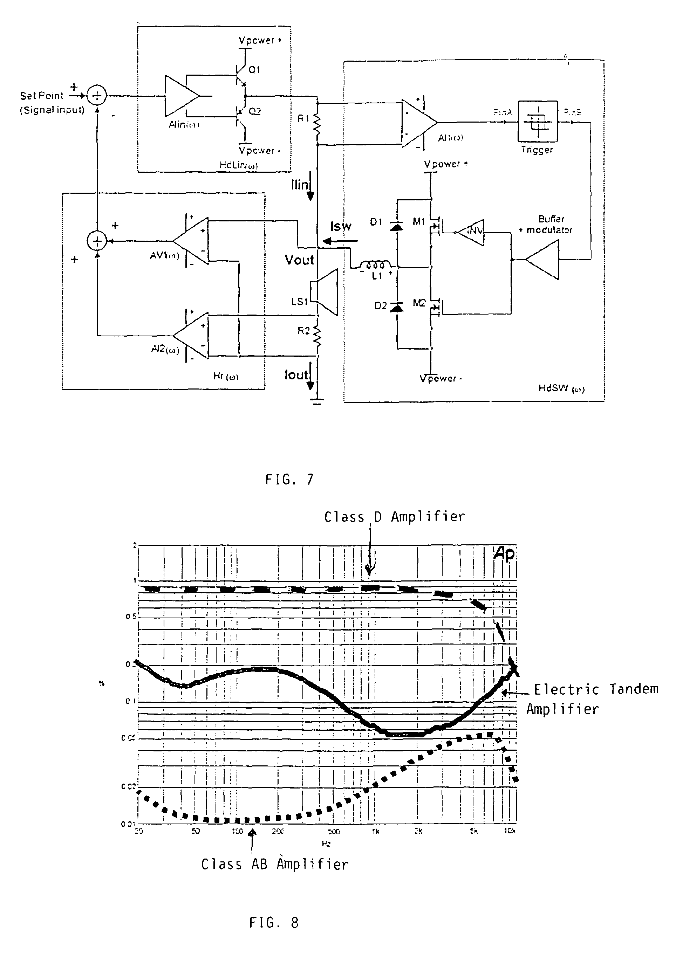

In Figure 6 the currents present in the hybrid amplifier excited with a sinusoidal input according to the present invention are shown: in particular it can be noticed in which way the output current of the linear amplifier (linear current) acts as a real compensator towards the output current of the switching amplifier (switching current) showing a sinusoidal waveform with a overlapped ripple due to the intrinsic distortion of the switching amplifier. Their combination generates the real output current of the "Electric Tandem" amplifier according to the present invention, i.e. it generates the current flowing into the loudspeaker. As it can be noticed, the output current does not have distortions and looks like the sinusoidal curve to be reproduced. In Figure 7 the wiring diagram of the "Electric Tandem" amplifier according to the present invention is shown. The linear amplifier marked with $Hd_{lin}$ supplies a current $I_{lin}$ fed back through a shunt R1 and sent to the switching amplifier $Hd_{sw}$ that supplies a current $I_{sw}$ through two power switches M1, M2 (usually power MOSFET).

The two currents $I_{lin}$ and $I_{sw}$ sum up according to the first Kirchoff law, supplying a current I flowing through a loudspeaker LS1. The current $I_{out}$ is then fed back through a shunt R2 and a differential amplifier AI2.

The output signal of the differential amplifier AI2 is subtracted to the input signal and the result is sent to the input of the linear amplifier $Hd_{lin}$.

The combination of the currents $I_{lin}$ and $I_{sw}$ providing the $I_{out}$ result is well shown in Figure 6 wherein $I_{lin}$ is the "linear current", $I_{sw}$ is the "switching current" and $I_{out}$ is the "Electric Tandem current".

The feedback of the current $I_{out}$ and of the voltage $V_{out}$ across the loudspeaker LS1 obtained through the transfer function $Hr(\omega)$ which is the combination of the two transfer functions $AV1(\omega)$ and $AI2(\omega)$ allows the linear amplifier with transfer function $Hd_{lin}(\omega)$ to make the current $I_{out}(\omega)$ follow the input voltage (Set point) as much as possible.

At the same time, by the feedback in voltage $V_{out}(\omega)$ the gain of the "Electric Tandem" amplifier is obtained.

In particular, with the feedback Hr the error signal allowing the linear amplifier $Hd_{lin}$ to generate an output current called $I_{lin}$ containing both a portion of the usual current $I_{out}$ and the replica, exactly in push pull, of the ripple unavoidably generated by the switching amplifier on the current $I_{sw}$ is generated.

The optimum adjustment depends on the load, particularly AV1 can be set to zero obtaining the pure feedback in current.

Figure 8 shows the total harmonic distortion plus noise, THD+N (Total Harmonic Distortion + Noise) according to the frequency and with the same power on a purely resistive load of an "Electric Tandem" amplifier compared with the one of a linear (Class B) amplifier and with the one of a switching (Class D) amplifier. It can be deduced that the "Electric Tandem" amplifier keeps the linear amplifier distortion low, together with the high efficiency of the switching amplifier.

**Claims**

1.    A hybrid architecture audio power amplifier receiving an input signal (Audio in), said amplifier comprising:

  - a linear amplifier (Hdlin);
  - a switching amplifier (Hdsw);
  - an **electric** coupling circuit connecting the outputs of said linear and switching amplifiers (Hdlin, Hdsw,) formed as a node summing the output current (Ilin) supplied by said linear amplifier (Hdlin) and the output current (Isw) supplied by said switching amplifier (Hdsw;)
  - a load (LS1) into which flows the output current (Iout) from said node;
  - a feedback circuit for feeding back said output current (Iout) which is fed back to the input signal;

  **characterized in that** the feedback transfer function $Hr(\omega)$ is constituted by the combination of two transfer function $AV1(\omega)$ and $AI2(\omega)$ and rendered proportional to said input signal(Audio in).

2.    The audio power amplifier according to claim 1, **characterized in that** said current (Ilin) from linear amplifier (Hdlin) is fed back through a shunt (R1) and is sent to said switching amplifier (Hdsw) that in turn supplies an output current (IsW) through power switches M1, M2.

3.    The audio power amplifier according to the claims 2, **characterized in that** said current (Iout) is fed back through a shunt resistor (R2) and a differential amplifier AI2.

4.    The audio power amplifier according to claim 3, **characterized in that** the output signal of said differential amplifier (AI2) is subtracted from the input signal (Audio In) and the result is fed to the input of said linear amplifier (Hdlin).

5.    The audio power amplifier according to claims 1 to 4, **characterized in that** said transfer function $Hr(\omega)$ has a frequency waveform determining the bandwidth of the hybrid amplifier and supplies a mixed voltage-current feedback relating the voltage and the current across said load (LS1).

6.    The audio power amplifier according to claims 1 to 5, **characterized in that** the said switching amplifier (Hdsw) with a transfer function $Hdsw(\omega)$, acts as a current generator and is controlled by said linear amplifier (Hdlin).

7.    The audio power amplifier according to claims 1 to 5, **characterized in that** said linear amplifier (Hdlin) compensates the current ripples produced by said switching amplifier (Hdsw).

8.    The audio power amplifier according to claims 1 and from 5 to 7, **characterized in that** the signal generated by said linear amplifier (Hdlin) which comprises an error signal derived from the feedback, generates an output current (Ilin) containing both a portion of the useful current (Iout) and the replica, in push-pull, of the ripple generated by said switching amplifier (Hdsw).

FIG. 1

switching current

linear current

sum of virtual currents

FIG. 2

FIG. 3

FIG. 4

FIG. 5

switching current

linear current

Electric Tandem current

switching current

Electric Tandem current

FIG. 6

FIG. 7

FIG. 8

**EUROPEAN SEARCH REPORT**

Europäisches Patentamt
European Patent Office
Office européen des brevets

Application Number

EP 09 01 5298

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 5 329 245 A (HAMMOND RUSSELL E ET AL) 12 July 1994 (1994-07-12) * abstract; figures 7,1 * | 1 | INV. H03F1/02 H03F1/32 H03F3/181 H03F3/21 H03F3/217 H03F3/68 |
| A | US 4 346 349 A (YOKOYAMA KENJI) 24 August 1982 (1982-08-24) * abstract * | 1 | |
| A | US 5 905 407 A (MIDYA PALLAB) 18 May 1999 (1999-05-18) * abstract * | 1 | |
| A | DE 199 47 808 A1 (PHILIPS CORP INTELLECTUAL PTY) 12 April 2001 (2001-04-12) * abstract * | 1 | |
| X | US 5 170 132 A (LUCAS JEAN-CHRISTOPHE [FR] ET AL) 8 December 1992 (1992-12-08) * figures 3, 4 * | 1-4 | |
| A | NAM-IN KIM ET AL: "Ripple feedback filter suitable for analog/digital mixed-mode audio amplifier for improved efficiency and stability" 33RD.ANNUAL IEEE POWER ELECTRONICS SPECIALISTS CONFERENCE. PESC 2002. CONFERENCE PROCEEDINGS. CAIRNS, QUEENSLAND, AUSTRALIA, JUNE 23 - 27, 2002; [ANNUAL POWER ELECTRONICS SPECIALISTS CONFERENCE], NEW YORK, NY : IEEE, US, vol. 1, 23 June 2002 (2002-06-23), pages 45-49, XP010596063 ISBN: 978-0-7803-7262-7 * the whole document * | 1,4 | TECHNICAL FIELDS SEARCHED (IPC) H03F |

The present search report has been drawn up for all claims

| Place of search | Date of completion of the search | Examiner |
|---|---|---|
| Munich | 17 March 2010 | Agerbaek, Thomas |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 09 01 5298

This annex lists the patent family members relating to the patent documents cited in the above-mentioned European search report.
The members are as contained in the European Patent Office EDP file on
The European Patent Office is in no way liable for these particulars which are merely given for the purpose of information.

17-03-2010

| Patent document cited in search report | | Publication date | Patent family member(s) | | Publication date |
|---|---|---|---|---|---|
| US 5329245 | A | 12-07-1994 | NONE | | |
| US 4346349 | A | 24-08-1982 | DE | 3017521 A1 | 13-11-1980 |
| | | | JP | 1324627 C | 27-06-1986 |
| | | | JP | 55149512 A | 20-11-1980 |
| | | | JP | 60052607 B | 20-11-1985 |
| US 5905407 | A | 18-05-1999 | NONE | | |
| DE 19947808 | A1 | 12-04-2001 | NONE | | |
| US 5170132 | A | 08-12-1992 | AT | 101766 T | 15-03-1994 |
| | | | CA | 2050819 A1 | 15-03-1992 |
| | | | DE | 69101202 D1 | 24-03-1994 |
| | | | DE | 69101202 T2 | 26-05-1994 |
| | | | DK | 0475835 T3 | 14-03-1994 |
| | | | EP | 0475835 A1 | 18-03-1992 |
| | | | FR | 2666944 A1 | 20-03-1992 |
| | | | JP | 3186806 B2 | 11-07-2001 |
| | | | JP | 4271506 A | 28-09-1992 |

EPO FORM P0459

For more details about this annex : see Official Journal of the European Patent Office, No. 12/82